# EUROPEAN PATENT SPECIFICATION

(11) **EP 3 243 005 B1**
(45) Date of publication and mention of the grant of the patent: **28.08.2019**
(21) Application number: 16700505.7
(22) Date of filing: 06.01.2016
(51) Int. Cl.: F04C 25/02

(54) **IMPROVEMENTS IN OR RELATING TO VACUUM PUMPING ARRANGEMENTS**
VERBESSERUNGEN AN ODER IM ZUSAMMENHANG MIT VAKUUMPUMPANORDNUNGEN
AMÉLIORATIONS APPORTÉES À OU ASSOCIÉES À DES AGENCEMENTS DE POMPAGE À VIDE

(30) Priority: 06.01.2015 GB 201500133
(43) Date of publication of application: 15.11.2017
(73) Proprietor: Edwards Limited, Burgess Hill West Sussex RH15 9TW (GB)
(72) Inventor: SCHOFIELD, Nigel Paul, Burgess Hill Sussex RH15 9TW (GB); SEELEY, Andrew, Clevedon Somerset BS21 6TH (GB); TATTERSALL, Jack Raymond, Bonbeach, Victoria 3196 (AU); TURNER, Neil, Burgess Hill Sussex RH15 9TW (GB)
(74) Representative: Rawlins, Kate Cecilia
(86) International application number: PCT/GB2016/050018
(87) International publication number: WO 2016/110694

(56) References cited:
- WO-A1-2006/097679
- WO-A1-2008/017880
- CN-A- 101 922 437
- JP-A- 2010 167 338
- JP-B2- 5 377 666

## Description

This invention relates to a vacuum pumping arrangement for use in a semiconductor fabrication facility, a semiconductor fabrication tool including such a vacuum pumping arrangement, and a semiconductor fabrication facility including a plurality of semiconductor fabrication tools each of which includes such a vacuum pumping arrangement.

Vacuum pumping arrangements are used extensively in connection with semiconductor fabrication, e.g. the manufacture of silicon chips, flat panel displays, solar panels and light emitting diodes (LEDs). There is a need to improve the efficiency of such pumping arrangements, particularly in relation to the manufacture of silicon chips.

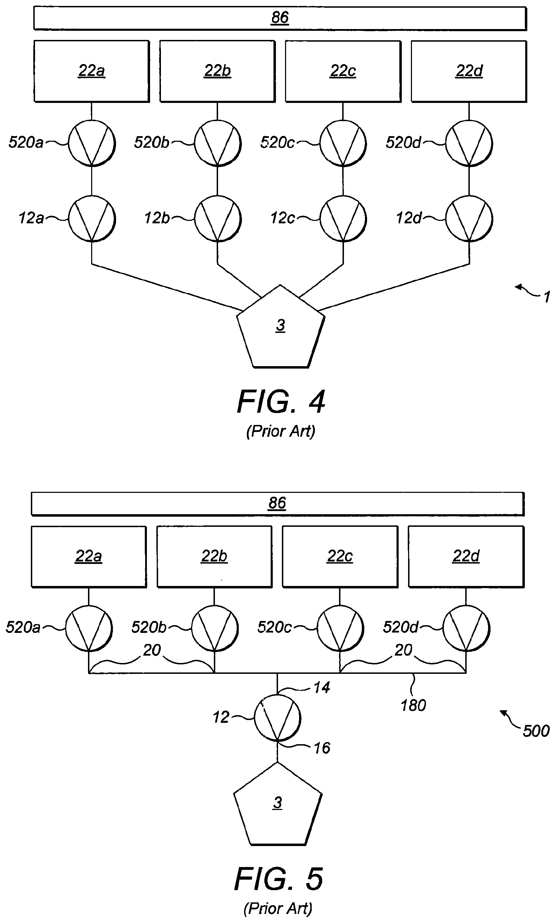

Figure 4 illustrates schematically a known vacuum pumping arrangement 1 for evacuating several process chambers 22a, 22b, 22c, 22d of a process tool 86. In the example illustrated in figure 4, each process chamber 22a, 22b, 22c, 22d is evacuated by both at least one secondary pump 520a, 520b, 520c, 520d, for example a roots booster pump and/or a turbomolecular pump; and a primary pump 12a, 12b, 12c, 12d, for example a multistage roots, claw or screw type dry vacuum pump, respectively. For example, first process chamber 22a is in fluid communication with and evacuated by first secondary pump 520a and first primary vacuum pump 12a. It is common for a plurality of similar or identical processing steps to be carried out in each processing chamber 22a, 22b, 22c, 22d for example a first processing step could be a deposition step, and a second processing step could be a cleaning step. Any unused process gases and process by-products pass through the respective secondary 520 and primary pumps 12 and are exhausted to a single type of abatement module 3 which must be able to destroy all the exhaust gases conveyed to it.

Another know vacuum pump arrangement 500 for evacuating several process chambers 22a, 22b, 22c, 22d of a process tool 86 is illustrated schematically in Figure 5. The vacuum pump arrangement 500 comprises a primary pump 12 having an inlet 14 and an outlet 16, and further comprises a common pumping line 180 fluidly connected to the primary pump inlet 14, the common pumping line 180 includes a plurality of pumping line inlets 20 each of which is fluidly connectable to at least one process chamber 22a, 22b, 22c, 22d within a group of process chambers 22 forming said semiconductor process tool 86. Each common pumping line inlet 20 is arranged in fluid communication with at least one chamber connecting line (foreline) which, in use, is fluidly connected to a respective process chamber 22. Each chamber connecting line includes at least one secondary pump 520 (a-d), such as a roots booster and/or turbomolecular pump fluidly connected therewith for evacuating each respective chamber 22 (a-d).

The provision of a common pumping line 180 which is fluidly connectable to each of a plurality of vacuum process chambers 22 within a group of vacuum process chambers 22 (a-d) that forms a semiconductor fabrication tool 86, allows a single primary vacuum pump 12 to service all of the process chambers of a given fabrication tool, and thereby reduces both the capital cost of installing the vacuum pumping arrangement 500, as well as the on-going running costs, compared to those associated with the conventional vacuum pumping arrangement as shown in Figure 4. The inclusion of at least one first secondary pump 520(a-d) in each foreline, for example a roots booster pump and/or a turbomolecular pump, helps to prevent pressure changes in one chamber 22 affecting the pressure within a second chamber 22, and also buffers, or protects, the pressure within a given chamber 22(a-d) from any pressure changes in the common pumping line 180.

A reduction in the number of primary vacuum pumps 12 required to service the process chambers 22 of a given fabrication tool 86 also reduces the space required to house the vacuum pumping arrangement..

The vacuum pumping arrangement 500 further includes a first abatement module (device) 3 arranged in fluid communication with the primary pump 12. The first abatement module 3 within such an arrangement 500 must also be able to treat the process flows from all of the process chambers 22 (a-d) of a given fabrication tool 86 simultaneously.

There is a need to improve the efficiency of such vacuum pumping and abatement arrangements.

JP 5377666 discloses a vacuum exhaustion apparatus that provides valves that allow a vacuum pump arranged in parallel with other pumps to evacuate a chamber in conjunction with the other pumps when the valve is in one position or to act as an auxiliary or backing pump and reduce the pressure at the exhaust of the other pumps when the valve is in a different position. By allowing this dual functionality of a pump the number of pumps required is reduced.

WO2006/097679 discloses a set of booster and backing pumps connected in parallel. During an initial phase of a vacuum evacuation a subset of the booster pumps is used, the others remaining running at full speed but isolated from the chamber. This avoids the booster pumps from being exposed to higher pressures which may cause them to overheat.

CN101922437 discloses a vacuum device comprising a plurality of pumping units for evacuating a plurality of chambers. The vacuum device comprises a plurality of higher vacuum pumps such as a turbo pumps and a plurality of lower vacuum pumps acting as backing pumps. There is a common pipeline and various valves between the backing pumps and turbo pumps allowing only a subset to be used to provide the lower pressure at the output of the turbo pumps during high vacuum operation and allowing all of them to be connected to the chambers when evacuating the chambers to the higher vacuum state. This allows power savings and reduces the hours of operation of the pumps.

JP2010167338 similarly discloses higher vacuum and lower vacuum pumps with valves to connect them to the chamber and/or each other or isolate them from the chamber depending on the operational point of the process, thereby saving power.

WO2008/017880 discloses an apparatus for conveying waste streams exhausted from first and second chambers. The apparatus comprises first conduit means comprising an inlet for receiving a waste stream exhausted from the first chamber, and an outlet, and a second conduit means comprising an inlet for receiving a waste stream exhausted from a second chamber, and an outlet. The outlets of the first and second conduit means are connected together. The first conduit means comprises means for generating sonic choking of gas being conveyed towards the outlet of the first conduit means in order to inhibit migration of a component of the waste stream exhausted from the second chamber towards the first chamber.

In a first aspect the present invention provides a vacuum pumping arrangement comprising:
a first primary pump having an inlet and an outlet, and a first common pumping line fluidly connected to the inlet of the first primary pump, the first common pumping line including a plurality of first common pumping line inlets each of which is fluidly connectable to at least one vacuum process chamber within the group of process chambers forming the semiconductor fabrication tool, the first primary pump and the first common pumping line, in use, handling deposition process flows; and
a second primary pump having an inlet and an outlet, and a second common pumping line fluidly connected to the inlet of the second primary pump, the second common pumping line including a plurality of second pumping line inlets each of which is fluidly connectable to at least one process chamber within the group of process chambers forming the semiconductor fabrication tool, the second primary pump and the second common pumping line, in use, handling cleaning process flows; wherein
respective pairs of first and second common pumping line inlets are each fluidly interconnected by a valve module (106) which in turn is fluidly connectable to a said at least one process chamber such that an exhaust of said at least one process chamber is directed to either said first or second common pumping line.

The inclusion of first and second primary pumps and associated first and second common pumping lines still provides an improved cost and space utilisation efficiency compared to the process tool illustrated in figure 4, while permitting optimisation of the respective primary pump according to the nature of the process flow passing therethrough. The present invention thereby provides further efficiency savings. For example primary pumps required to pump deposition gases are often required to operate at temperatures above, for example, 100°C to 80°C to prevent deposition exhaust gases, such as tetraethylorthosilicate (TEOS), collecting within the pumping mechanism, whereas primary pumps evacuating halogenated etch/chamber cleaning gases are often required to run cooler than, for example, 1000 °C -80 °C to reduce the rate of corrosion in the pumping mechanism.

The inclusion of a valve module enables a particular process chamber exhaust to be directed to either the first or second common pumping lines depending on the composition of the fluid being exhausted from the process chamber at a given time, namely dependent on what processing step is being carried out in said chamber. In some respect it also reduces the amount of pipeline required between the common pumping line and each corresponding process chamber, compared to the installation of two forelines from each chamber, and so provides a commensurate installation cost saving.

Preferably each of the first and second primary pumps has a respective abatement module arranged in fluid communication therewith. Such an arrangement permits optimisation of each abatement module according to the process flow, i.e. deposition or etch/cleaning, passing therethrough, thereby helping to ensure maximum efficiency of each abatement module compared to a single abatement module provided to abate all the unused process gases (precursors) and process by products exhausted from a chamber, or group of chambers. With this arrangement each abatement module can be chosen to be specifically designed for the abatement of, for example, fluorine, or (TEOS).

Optionally the abatement modules are or includes one of:
a plasma-based device;
a flame-based device; and
an oxidizer.

Plasma- and flame-based devices, especially in the presence of water and/or oxygen provide a desired breakdown of perfluorocarbons (PFCs), such as CF₄, NF₃, SF₆ etc., following, e.g. an etch process in a process chamber or a process chamber cleaning process, and also produce fine dry powders from deposition gases such as silane and tetraethylorthosilicate (TEOS). However, the addition of water and/or oxygen to a plasma based device for the destruction of deposition gases is undesirable. An oxidizer usefully burns process gas flows with reduced NOₓ emissions.

The abatement modules may be located:
upstream of a primary pump;
downstream of a primary pump; and
at an interstage of a primary pump.

Mounting the abatement module upstream, or at an interstage, of one of the primary pumps means exhaust gases comprising etch gases such as PFCs are destroyed before they are substantially diluted with nitrogen purge, thus reducing the power requirements of the abatement module. It is well known that the power requirements of an abatement module increases with increasing gas dilution.

In addition to the reduced dilution of a process flow afforded by having the abatement module arranged at an interstage of the primary pump, it also permits sub-atmospheric abatement at approximately 200 mbar, which provides an increase in safety when handling flammable fluids (SiH₄, TEOS etc.) exhausted from the process chambers because any potential explosive fluid would have lower pressure limits. Furthermore, arrangement at an interstage of the primary pump provides a very integrated primary pump and abatement arrangement which is readily installable in a compact and efficient manner.

Arranging the abatement module downstream of the primary pump has the benefit of avoiding the need for a heat exchanger immediately following, e.g. an oxidizer.

In another preferred embodiment of the invention at least one valve module includes a fail-safe arrangement, for example a one way valve, to prevent the accidental mixing of deposition and cleaning process flows upstream of the valve module. Such an arrangement helps to ensure safe operation of the vacuum pumping arrangement

At least one valve module may be located downstream of any of the at least one first or second secondary pump associated with the corresponding process chamber. For example the valve module could be located downstream of a turbomolecular pump, but upstream of a roots booster pump in a given chamber connecting foreline. The at least one valve module is preferably located downstream of the roots booster to ensure the process tool is protected from pressure variations and back migration of process gases.

Such location of a valve module helps to minimise the size and cost of the valve module.

Preferably the second common pumping line is selectively fluidly connectable with the first primary pump in isolation from the first common pumping line.

The ability to, as required, fluidly connect the second common pumping line with the first primary pump permits selective cleaning of the first primary pump, i.e. removal of any deposition process by-products from the first primary pump. By selectively passing etch, or clean process by-product exhaust gases (halogenated gases) through the first primary pump it is possible to periodically clean the internal vacuum pump mechanism. Thus improving the time between service intervals for the first primary pump.

The second primary pump, primarily designed to pump the cleaning step gases and their corrosive by-products, will preferably utilise corrosion resistant materials for one or more parts of the or each pump. This will increases the cost of the pump to a certain degree despite the advantages of providing a dedicated cleaning gas primary pump.

However, it is also possible to selectively fluidly connect the first common pumping line (used for pumping deposition process by-product gases for example) with the second primary pump in isolation from the second common pumping line to allow small amounts of "protective" deposits build up on and accumulation member such as the internal vacuum pump mechanisms to reduce the effect of the corrosive gases. Thus providing for a less corrosion resistant pump to be required for the second primary pump.

Embodiments provide a vacuum pumping arrangement, for use in a semiconductor fabrication assembly, comprising:
a primary pump configured principally to handle cleaning process flows, the pump having arranged therein an accumulation member lying in fluid communication with the internal swept volume of the pump; and
a control module configured to operate the pump during a deposition step and a subsequent cleaning step which together define a deposition-clean cycle, the control module during the deposition step selectively diverting a deposition process flow through the internal swept volume of the pump whereby a deposition residue accumulates on the accumulation member, the control module during the cleaning step allowing a cleaning process flow to flow through the internal swept volume of the pump whereby the cleaning process flow reacts with the deposition residue and removes at least a portion of the deposition residue from the accumulation member, and the control module monitoring at least one of the accumulation and the removal of deposition residue from the accumulation member and controlling a characteristic of at least one of the deposition process residue accumulation step and the cleaning process deposition reaction step in response to said monitoring to control the level of deposition residue remaining at the end of a deposition-clean cycle.
Having the control module selectively divert a deposition process flow through the internal swept volume of the pump whereby a deposition residue accumulates on the accumulation member means that during the cleaning step, i.e. essentially normal operation of the pump, any aggressive constituents of the cleaning process flow, e.g. any un-reacted cleaning gas, preferentially attacks the deposition residue rather than attacking the interior of the pump.

In addition, having the control module monitor at least one of the accumulation and the removal of deposition residue from the accumulation member helps to avoid one or both of either the accumulation of too much deposition residue (which might otherwise fill pumping clearances and thereby reduce the reliability of the pump), or the complete removal of the deposition residue before the cleaning step is complete (which might otherwise allow any un-reacted cleaning gas to attack the interior of the pump).

Moreover, such functionality is provided without the need to employ expensive, corrosion resistant, materials for any parts of the pump, and so the cost of the vacuum pumping arrangement is not unduly increased,

It is possible to monitor the thickness of deposit by monitoring the temperature profile of the pump, or the motor current profile to look for abnormalities caused by the decrease in running clearances in the pump as the deposition residue accumulates.

In a preferred embodiment of the invention the accumulation member includes a residue thickness monitor coupled therewith and the control module monitors at least one of the accumulation and the removal of deposition residue from the accumulation member by interpreting signals from the residue thickness monitor to determine the thickness of the deposition residue on the accumulation member.

The inclusion of a residue thickness monitor provides a relatively accurate and real-time indication of the level of deposition residue on the accumulation member, and so facilitates the control module in ensuring that a desired amount of deposition residue remains on the accumulation member at the end of a deposition-clean cycle.

Optionally the control module monitors the accumulation of deposition residue on the accumulation member using the stoichiometry of the reaction between the deposition residue and cleaning gas by determining the volume of deposition process flow which passes through the pump during the deposition step, and/or the control module monitors the removal of deposition residue from the accumulation member by determining the volume of cleaning process flow which passes through the pump during the cleaning step.

The control module may include timer module, and the control module may monitor the accumulation of deposition residue on the accumulation member by determining the period of time for which the deposition process flows, and/or the control module may monitor the removal of deposition residue from the accumulation member by determining the period of time for which the cleaning process flows.

The foregoing arrangements provide a ready means of at least estimating the amount of deposition residue on the accumulation member in a manner which requires little or no additional modification to a pump.

Preferably the accumulation member includes a cooling element, and the control module is configured to selectively operate the cooling element during the deposition step to cool the accumulation member and thereby selectively increase the rate of accumulation of deposition residue on the accumulation member.

Such an arrangement allows the control module to increase the level of deposition residue on the accumulation member, as desired, e.g. in the event of a large volume of cleaning process flow being expected during the cleaning step.

In an embodiment not part of the invention the accumulation member includes a heating element, and the control module is configured to selectively operate the heating element during the cleaning step to heat the accumulation member and thereby selectively increase the rate of removal of deposition residue from the accumulation member.

Such an arrangement allows the control module to reduce the level of deposition residue on the accumulation member, as desired, e.g. in the event that the level of deposition residue may begin to adversely impact on the reliability of the pump.

The accumulation member can be a separate member attached to the pump and/or the internal surfaces of the pumping mechanism. The heating and cooling can be effected using a stand-alone heater and cooling device, or using the cooling circuit of the pump by varying the temperature of the cooling fluid circulated.

Optionally the control module monitors at least one of the accumulation and the removal of deposition residue from the accumulation member and controlling a characteristic of at least one of the deposition process residue accumulation step and the cleaning process deposition reaction step in response to said monitoring to control the level of deposition residue remaining at the end of a deposition-clean cycle. Leaving substantially no deposition residue on the accumulation member at the end of the deposition-clean cycle is advantageous since it means that no more deposition residue accumulated than was required to preferentially remove the aggressive constituents from the cleaning process flow, and so unnecessary waste of the deposition process flow constituents is avoided.

It will be apparent that it is also possible to monitor the thickness of deposition residce accumulated on an accumulation member in the first primary pump, namely the one configured for normally pumping the deposition process by-products, and selectively divert cleaning gases through the first primary pump until the deposition process residue has been substantially removed therefrom.

According to a further technique there is provided a method of controlling a vacuum pumping arrangement during a deposition step and a subsequent cleaning step which together define a deposition-clean cycle, the vacuum pumping arrangement including a pump configured principally to handle cleaning process flows and having arranged therein an accumulation member lying in fluid communication with the internal swept volume of the pump, the method comprising the steps of:
(a) during the deposition step selectively diverting a deposition process flow through the internal swept volume of the pump whereby a deposition residue accumulates on the accumulation member;
(b) during the cleaning step allowing a cleaning process flow to flow through the internal swept volume of the pump whereby the cleaning process flow reacts with the deposition residue and removes at least a portion of the deposition residue from the accumulation member;
(c) monitoring at least one of the accumulation and the removal of deposition residue from the accumulation member; and
(d) controlling a characteristic of at least one of the deposition process residue accumulation step and the cleaning process deposition reaction step in response to said monitoring to control the level of deposition residue remaining at the end of a deposition-clean cycle.

However, as described above, it is preferable that both the first and second primary pumps associated with the first and second common pumping lines are chosen for optimum pumping ability and service interval lifetime for the exhaust gases pumped down said first and second common pumping line to which they are more often fluidly connected thereto.

In a preferred embodiment of the invention at least the first or second common pumping line includes an interconnecting member fluidly connectable to a common pumping line of at least one other vacuum pumping arrangement.

The invention also preferably includes at least two pumping arrangements, as described above, wherein at least one of the common pumping lines is fluidly interconnected by respective interconnecting members.

The ability to fluidly interconnect at least the first or second common pumping lines of respective vacuum pumping arrangements via, for example, a valve arrangement provides the option of including a degree of primary pump and/or abatement module redundancy within, e.g. a semiconductor fabrication facility, to accommodate the breakdown or maintenance of a primary pump, or an abatement module, without the need to shut down the whole fabrication facility. In addition, the additional evacuated volume provided by the interconnecting pipelines of each common pumping line can provide a degree of buffering against any pressure changes within the facility.

The vacuum pumping arrangement may further include one or more rough down pumping lines, each having a first end arranged in fluid communication with at least one of the first or second primary pumps and a second end including a bleed valve, the bleed valve being fluidly connectable to a respective process chamber to initially evacuate the said process chamber.

Conveniently the first end of the rough down pumping line is arranged in fluid communication with the primary pump via one of:
a pumping line inlet of the common pumping line; and
an interstage of the primary pump.

Alternatively the vacuum pumping arrangement may further include one or more rough down pumping lines, and wherein each valve module has an additional outlet and the first end of the rough down pumping line is arranged in fluid communication with a third common pumping line comprising a third or further primary pump and the second end of the rough down pumping line is in fluid communication with the additional outlet of the valve module.

The inclusion of one or more rough down pumping lines having the aforementioned features helps to minimise pressure fluctuations within the vacuum pumping arrangement which both protects the processes in other process chambers and minimises perturbation (disruption) of the downstream abatement modules.

According to a further aspect of the invention there is provided a semiconductor fabrication facility (factory) comprising a plurality of semiconductor fabrication tools each of which includes:
a plurality of process chambers; and
a vacuum pumping arrangement according to a first aspect wherein the common pumping line of the vacuum pumping arrangement of one semiconductor fabrication tool is fluidly connected to the common pumping line of the vacuum pumping arrangement of at least one other semiconductor fabrication tool.

Fluidly interconnecting the common pumping lines (used for pumping similar/compatible exhaust gas species/mixtures) of respective vacuum pumping arrangements provides a degree of primary pump and/or abatement module redundancy within the semiconductor fabrication facility, which permits the facility to, for example, accommodate the servicing or breakdown of a primary pump and/or abatement module without the need to shut down the whole fabrication facility or a particular process tool.

According to a still further aspect of the invention there is provided a vacuum pumping arrangement according to a first aspect for evacuating at least first and second vacuum process chambers, wherein said first vacuum pump inlet is in fluid communication with an outlet of the first process chamber, said second vacuum pump inlet in fluid communication with an outlet of the second process chamber; at least first and second valve modules, said valve modules being at least three way valve
modules comprising an inlet, a first outlet and a second outlet, said first valve module inlet in fluid communication with an outlet of the first vacuum pump, said second valve arrangement inlet in fluid communication with an outlet of the second vacuum pump; at least first and second common pumping lines, the first common pumping line in fluid communication with the first outlets of both of the first and second valve modules, the second common pumping line in fluid communication with the second outlets of both the first and second valve modules, wherein the first and second vacuum pumps are secondary vacuum pumps and each of the first and second common pumping lines comprises at least respective first and second primary vacuum pump to provide sufficient pumping capacity for each of the at least first and second vacuum pumps when in fluid communication via the first and/or second valve modules; and wherein at least one of the common pumping lines is in fluid communication with an abatement device.

The provision of the at least three way valve modules for at least two process chambers and a plurality of common pumping lines in fluid communication with said valve modules allows for common process flows, namely chemically similar, or compatible, unused process gasses (precursors) and their by-products exhausted from different process chambers to be directed, via the valve module, to a common pumping line (conduit). Thus, the chemically similar, or compatible, unused process gasses (precursors) and their by-products directed to each common pumping conduit (exhaust pipe) can then treated in a more specific, suitable, and therefore efficient, abatement device for said exhaust gas flow type. In addition, the utilisation of such an apparatus also means that the primary vacuum pumps can also be optimised for a particular process flow.

It is preferable that the first common pumping line is in fluid communication with a first abatement device and the second common pumping line is in fluid communication with a second abatement device so that the process exhaust gases conveyed to each of said common pumping lines can be directed to an abatement module optimised for said exhaust gases conveyed thereto.

The at least first and second vacuum pumps are preferably selected from at least one of a roots booster vacuum pump and/or a molecular vacuum pump and the at least first and second primary vacuum pumps are selected from at least one of a claw, roots, screw, scroll, rotary vane and liquid ring vacuum pump depending on the composition and flow rates of exhaust gases directed to each of the at least first and second common pumping lines.

It is possible to control the valves manually, but it is preferred that the vacuum pump arrangement further comprises a controller configured to control the valve modules, vacuum pumps and abatement modules dependent on a received signal, said signal indicating the composition of the gases exhausted from the at least first and/or second vacuum process chambers. This provides a more efficient solution compared to manually monitoring the processes and switching the valve modules gases.

There now follows a brief description of preferred embodiments of the invention, by way of non-limiting example, with reference being made to the following figures in which:
Figure 1 shows a schematic view of a vacuum pumping arrangement according to a first embodiment of the invention;
Figure 1b shows a schematic view of a portion of the vacuum pumping arrangement according to a first embodiment of the invention;
Figure 2 shows a schematic view of a vacuum pumping arrangement according to a second embodiment of the invention;
Figure 3 shows a schematic view of a vacuum pumping arrangement according to a third embodiment of the invention;
Figure 4 shows a schematic view of a known vacuum pumping arrangement; and
Figure 5 shows a schematic view of a further known vacuum pumping arrangement.
Figures 6a and 6b show schematic views of the protective deposition and cleaning pumping arrangement.

A vacuum pumping arrangement according to a first embodiment of the invention is designated generally by reference numeral 70.

The first vacuum pump arrangement 70 includes a first primary pump 72, selected from, for example, at least one of a multistage claw and/or roots, screw, scroll, rotary vane and liquid ring vacuum pump, which has a first inlet 74 and a first outlet 76. The first inlet 74 is fluidly connected to a first common pumping line 78 which includes four first pumping line inlets 80. In other embodiment of the invention (not shown) the common pumping line 78 may include fewer than or more than four pumping line inlets 80. Each first pumping line inlet 80 is, in use, fluidly connected to a single process chamber 22 within a group of process chambers forming part of a first semiconductor fabrication tool 86.

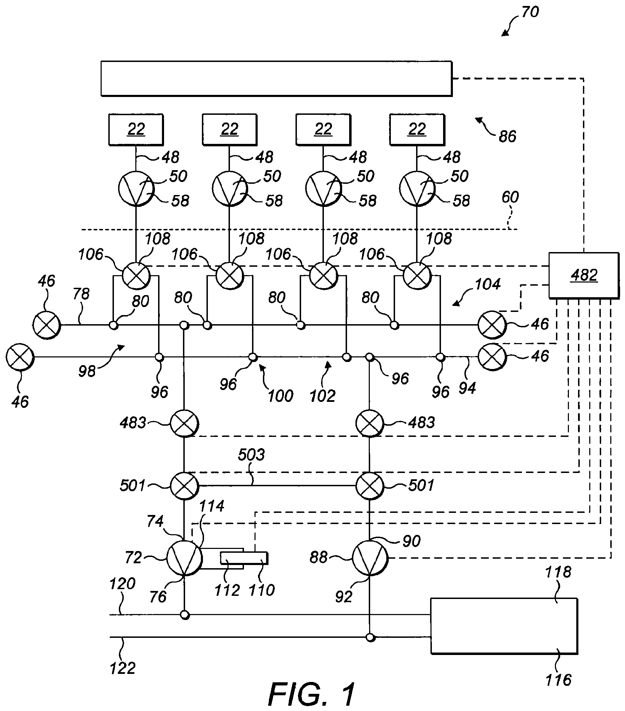

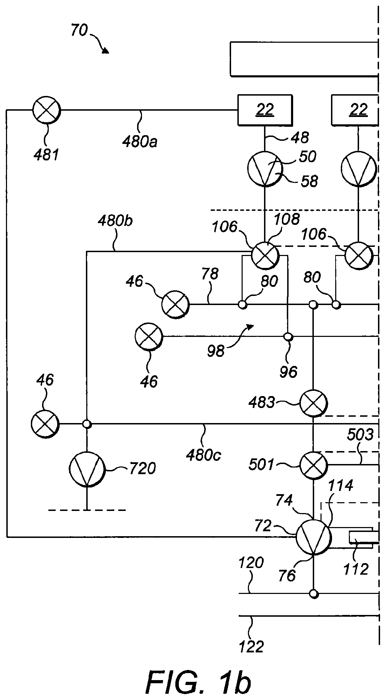

The first semiconductor fabrication tool 86 is configured to manufacture silicon chips, but could also equally be configured to manufacture flat panel displays, solar panels or LEDs. The tools 86, illustrated in figures 1, 2 and 3 are a chemical vapour deposition tool (CVD) in which both deposition and chamber cleaning steps are carried out.

The first vacuum pump arrangement 70 also includes a second primary pump 88, also selected from, for example, at least one of a multistage claw and/or roots, screw, scroll, rotary vane and liquid ring vacuum pump, which has a second inlet 90 and a second outlet 92. The second inlet 90 is fluidly connected to a second common pumping line 94 which in this example also includes four second pumping line inlets 96. Each second pumping line inlet is, in use, fluidly connected to a single process chamber 22 within the first semiconductor fabrication tool 86.

Respective pairs 98, 100, 102, 104 of first and second pumping line inlets 80, 96 are fluidly interconnected by a valve module 106 which in turn is, in use, fluidly connected to a corresponding process chamber 22.

Each valve module 106 includes a fail-safe arrangement (not shown), such as a one way valve, a mechanical interlock or an electronic handshake, to prevent mixing of different, possibly incompatible, process flows downstream (i.e. in the common pumping lines 78, 94) or upstream (i.e. in the process chamber 22) of the valve module 106.

In the embodiment shown the valve module 106 includes a three-way valve 108. In other embodiments, however, the valve module 106 may include a different valve arrangement, e.g. a pair of simple valves and a two-way pipeline branch.

The first vacuum pumping arrangement 70 also includes a first abatement module 110 which is arranged in fluid communication with the first primary pump 72.

The first abatement module 110 in the first embodiment is a DC plasma device 112 which is arranged at an interstage port 114 of the first primary pump 72. The first abatement module 110, however, also includes a process flow cooling element, i.e. a heat exchanger, (not shown) and particulate trap (not shown) which are located downstream of the DC plasma device 112 to provide a degree of protection to the vacuum pump 72. In addition, the first abatement module 110 may include a fluid inlet (not shown) to allow the introduction of, e.g. nitrogen or air, to urge any particles produced by the DC plasma device 112 through the first abatement module 110.

In other embodiments of the invention the first abatement module 110 may also be or include a radio frequency (RF) plasma device, a microwave plasma device, or a flame-based device; and it may alternatively be arranged upstream or downstream of the first primary pump 72.

In addition, the first vacuum pumping arrangement 70 includes a second abatement module 116 which is arranged downstream of and in fluid communication with the first abatement module 110. The second abatement module 116 is in the form of a wet scrubber 118.

A first common scrubber line 120 which, in use, may also be fluidly connected to a similar first common scrubber line 120 of another vacuum pumping arrangement (not shown), fluidly connects the wet scrubber 118 with the first abatement module 110, via the first primary pump 72. In this manner a single wet scrubber 118 is able to service a number of first primary pumps 72 in otherwise separate second semiconductor fabrication tools 86.

The second abatement module 116, i.e. the wet scrubber 118, is also arranged in fluid communication with the second primary pump 88, in such a way that the second abatement module 116 defines a 'first' abatement module from the perspective of the second primary pump 88.

The second abatement module 116, i.e. the wet scrubber 118, is fluidly connected to the second primary pump 88 by a second common scrubber line 122 which, in use, is fluidly connected to a similar second common scrubber line 122 of another vacuum pumping arrangement (not shown). As a result a single wet scrubber 118 is able also to service a number of second primary pumps 88 in otherwise separate second semiconductor fabrication tools 86 (as well as the number of first primary pumps 72 indicated above).

As an alternative, the second abatement module 116, i.e. the wet scrubber 118, may be fluidly connected solely to only a single first primary pump 72 and/or to only a single second primary pump 88.

The wet scrubber 118 may additionally include an electrostatic dust trap (not shown) to capture any dust particles passing therethrough.

The first and second abatement modules 110, 116 are chosen with sufficient capacity to abate (treat) the total maximum possible simultaneous process exhaust gas/by-product gas flow from all four process chambers 22.

Each of the first and second common pumping lines 78, 94 additionally includes first and second interconnecting members 46 each of which is, in use, fluidly connected to a corresponding first or second common pumping line (not shown) of another vacuum pumping arrangement. In other embodiments of the invention one or other of the first and second common pumping lines 78, 94 may include fewer than or more than two such interconnecting members.

Each of the interconnecting members takes the form of a simple valve 46, so as to allow selective disconnection of one common pumping line 78, 94 from another corresponding common pumping line 78, 94. Other types of interconnecting member are also possible however.

In addition to the foregoing, the first and second pumping line inlets 80, 96 within each respective pair 98, 100, 102, 104 are arranged in fluid communication, via the corresponding valve module 106, with a chamber connecting line 48 (foreline).

Each chamber connecting line 48 is, in use, fluidly connected to a respective process chamber 22.

Each chamber connecting line 48 also includes at least a first secondary pump 50, in the form of a roots blower 58, and/or a turbomolecular pump (not shown), which is fluidly connected therewithin. The first secondary pump 50 is, in each instance, located upstream of the corresponding valve module 106 and, advantageously, is located on the same floor 60 as, and directly mounted on, the corresponding process chamber 22 (i.e. in the clean room). Each at least first secondary pump 50 is preferably a two-stage roots booster vacuum pump 58 to produce a higher exhaust pressure (because it will have a higher compression ratio between its inlet and outlet compared to a single stage roots blower). The use of said two stage blower 58, allows for the use of a primary pump 72, 88 with a lower ultimate pressure rating than required with a single stage blower. In addition, the roots blower 58 reduces pressure fluctuations in process chambers caused by pressure changes in other process chambers connected via a common pumping line 78, 94.

In the alternative, a primary pump 72, 88 with a higher pumping speed may be used instead, or as well as the two-stage roots blower 58. The higher capacity primary pump 72, 88 can maintain or vary the pressure in the common pumping line by varying its rotational frequency and/or with the use of an additional flow control valve 483 located at its inlet.

The first vacuum pumping arrangement 70 also includes a controller 482 which, in use, communicates with the corresponding second semiconductor fabrication tool 86 and monitors the process flow composition within various regions of the first vacuum pumping arrangement 70.

The controller 482, advantageously includes a speed control module which controls the speed of the first and/or second primary pumps 72, 88 in order to help stabilise the pressure within the corresponding first or second common pumping lines 78, 94.

The controller is also configured to control the valves 106, the abatement modules 118, 110 and the valves 483.

The controller 482 controls which common pumping line 78, 94 the exhaust gases from the process chambers 22 are directed to via the valves 106 dependent on the signal indicating the composition of the exhaust gases from a particular chamber 22.

The first vacuum pumping arrangement 70 also includes a cleaning connecting line 503 which fluidly interconnects the second common pumping line 94 and the first primary pump 72. The cleaning connecting line further includes valve members 501 to selectively allow process flow to pass through the cleaning connecting line 503.

The ability to, as required, fluidly connect the second common pumping line 94 in isolation with the first primary pump 72 permits selective cleaning of the first primary pump 72, i.e. removal of any deposition process by-products from the first primary pump 72. By selectively passing etch, or clean process by-product exhaust gases (fluorinated gases) in isolation through the first primary pump 72 it is possible to periodically clean the internal vacuum pump mechanism.

It is also possible to selectively fluidly connect the first common pumping line (used for pumping deposition process by-product gases for example) 78 with the second primary pump 88 in isolation from the second common pumping 94 line to allow small amounts of "protective" deposits build up on the internal vacuum pump mechanisms of the second primary pump 88 to reduce the effect of the corrosive gases.

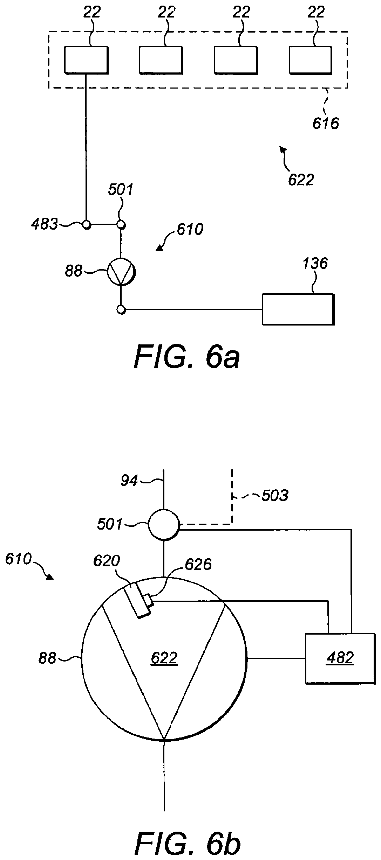

This protective deposition, or pump cleaning concept is illustrated in more detail in figures 6a and 6b.

In use a vacuum pumping arrangement 610 lies within a semiconductor fabrication assembly 622, as described above, and to this end is shown in Figure 6a fluidly connected to a process chamber 22 of a semiconductor fabrication tool 616. The vacuum pumping arrangement 610 also has a dedicated abatement module 136 fluidly connected downstream thereof.

In other embodiments of the invention the vacuum pumping arrangement 610 may be fluidly connected to a plurality of such process chambers 22 by the common cleaning gas pumping line 94. Indeed, still greater benefits of the invention are realised when the vacuum pumping arrangement 610 is configured principally to handle the cleaning process flows from each of a plurality of process chambers 22.

As shown most clearly in Figure 6b, the vacuum pumping arrangement 610 includes a pump 88 which is configured principally to handle cleaning process flows, e.g. cleaning gasses such as fluorine.

The pump 88 has arranged therein an accumulation member 610 which lies in fluid communication with the internal swept volume 622 of the pump 88. The accumulation member 610 may be formed from a metal or corrosion resistant plate such as stainless steel that can be subjected to cooling and heating cycles. The accumulation member may simply be the internal surfaces of the pumping mechanism with the cooling/heating circuit being that of the vacuum pump itself. The accumulation member may also be an additional plate or surface provided within the inlet to the pump.

The vacuum pumping arrangement 610 also includes a control module 482 which is operatively connected to the pump 88. In use the control module 482 operates the pump 88 during a deposition step and a subsequent cleaning step which, together, define a deposition-clean cycle.

The accumulation member 610 includes a residue thickness monitor 616 coupled therewith. One type of suitable residue thickness monitor 616 is a crystal oscillator film thickness monitor, although other thickness monitors are also possible.

The accumulation member 610 also includes a cooling element (not shown) and a separate heating element (not shown). In other embodiments of the invention the cooling and heating elements may be combined in a single temperature control element.

In use the control module 482, during the deposition step, selectively diverts a deposition process flow, e.g. via a valve 501 fluidly connected to a deposition pumping line 503, through the internal swept volume 622 of the pump 88.

During such flow a deposition residue, i.e. a reactive component of the deposition flow, accumulates on the accumulation member 610.

The control module 482 may, optionally, during the deposition step selectively operate the cooling element within the accumulation member 610 to cool the accumulation member 610. Such cooling of the accumulation member 610 promotes the condensing of deposition process flow onto the accumulation member 610, and so increases the rate at which deposition residue accumulates on the accumulation member 610.

During the subsequent cleaning step the control module 482 allows a cleaning process flow to flow through the internal swept volume 622 of the pump 88, e.g. by operating the valve 501 to fluidly connect the pump 88 to its associated cleaning gas pumping line 94.

During the flow of cleaning process flow through the pump 88 any aggressively corrosive constituents of the cleaning process flow, e.g. any remaining, un-reacted cleaning gas in the cleaning process flow, preferentially reacts with the deposition residue and removes it from the accumulation member 610.

The control module 482 may during this cleaning step, optionally, selectively operate the heating element to heat the accumulation member 610. Increasing the temperature of the accumulation member 610 increases the rate of reaction of the cleaning process flow with the deposition residue, and so increases the rate at which deposition residue is removed from the accumulation member 610.

During each of the deposition and cleaning steps the control module 482 monitors the respective accumulation and removal of deposition residue with respect to the accumulation member 610. More particularly, in the embodiment shown, the control module 482 interprets signals from the residue thickness monitor 616 to determine the thickness of deposition residue on the accumulation member 610, and hence the overall level of deposition residue remaining on the accumulation member 610.

In other embodiments of the invention the control module 482 may monitor only one of either the accumulation of deposition residue or the removal of deposition residue from the accumulation member 610.

In still further other embodiments of the invention (not shown) the control module 482 may alternatively monitor the accumulation and/or removal of deposition residue from the accumulation member 610 by:
- determining the volume of deposition process flow which passes through the pump during the deposition step, and/or determining the volume of cleaning process flow which passes through the pump during the cleaning step; or
- determining the period of time for which the deposition process flows, and/or determining the period of time for which the cleaning process flows.

Returning the embodiment shown, the control module 482 additionally alters a characteristic of each of the deposition residue accumulation step and the cleaning reaction step, i.e. cools the accumulation member 610 during the deposition residue accumulation step and/or heats the accumulation member 610 during the cleaning gas reaction step, in response to the aforementioned monitoring of the accumulation and removal of deposition residue from the accumulation member 610, so as to leave substantially no deposition residue on the accumulation member 610 at the end of the deposition-clean cycle.

In other embodiments of the invention the control module 482 may alter a characteristic of one or other of the deposition residue accumulation and cleaning gas reaction steps in order to leave a portion of deposition residue on the accumulation member 610 at the end of the deposition-clean cycle, or to remove all of the deposition residue from the accumulation member 610 before the end of the deposition-clean cycle.

It will be apparent that it is also possible to monitor the thickness of deposition residue accumulated on an accumulation member in the first primary pump 72, namely the one configured for normally pumping the deposition process by-products, and selectively divert cleaning gases through the first primary pump 72 until the deposition process residue has been substantially removed therefrom.

Referring again to figure 1, in use, the first primary pump 72 and the first common pumping line 78 handle a deposition process flow. The first abatement module 110, e.g. a DC plasma device 112, produces fine dry powders from deposition gases such as silane and TEOS during sub-atmospheric abatement, while the second abatement module 116, e.g. a second wet scrubber 118, collects the fine dry powders in the downstream deposition process flow.

Meanwhile, in use, the second primary pump 88 and the second common pumping line 94 handle a process chamber cleaning process flow with the second abatement module 116, i.e. the second wet scrubber 118, again removing fluorine and any other water soluble gases such as HF, SiF₄, COF₂ etc., in the cleaning process flow.

A portion of the first vacuum pumping arrangement 70 is shown in Figure 1b. It illustrates schematically two possible options for rough down pumping lines 480a, 480b, used to initially evacuate the process chambers 22 prior to processing steps being carried out.

A first rough down pumping line 480a has a first end which is arranged, in fluid communication with the primary pump 72 via the interstage 114. A second end of each rough down pumping line 480a includes a bleed valve 481 which, in use, is fluidly connected to a respective process chamber 22. The bleed valve and first rough down pumping line 480a are used to initially evacuate the process chamber in a controlled manner protecting the common pumping lines 78, 94, and therefore other process chambers 22, and abatement systems 110, 116, 118 from pressure fluctuations.

An alternative option (not shown) is for the first end of the rough down pumping line 480a and bleed valve 481 to be in fluid communication, via an additional inlet 80 of the common pumping line 78, with the primary pump 72 (or via inlet 96, common pumping line 94 and primary pump 88). Again the bleed valve 481 and first rough down pumping line 480a are used to initially evacuate the process chamber in a controlled manner protecting the common pumping line 78, and therefore other process chambers 22, and abatement systems 110, 116, 118 from pressure fluctuations.

An alternative second rough pumping line 480b has a first end which is arranged in fluid communication with a third common pumping line 480c comprising a third primary pump 720. Each valve module 106 comprises a third outlet in fluid communication with the second end of the second rough pumping line 480b. Thus, in use, when it is required to initially roughly evacuate the process chamber the gas is conveyed to the third primary pump 720 via the valve module 106 and third common pumping line 480c.

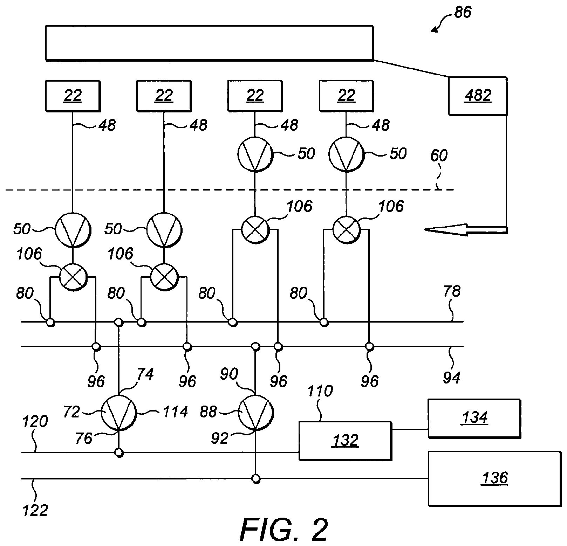

A vacuum pump arrangement 130 according to a second embodiment of the invention is illustrated schematically in Figure 2.

The second vacuum pump arrangement 130 is very similar to the first vacuum pump arrangement 70 shown in Figure 1, and like features share the same reference numerals.

However, one way in which the second vacuum pump arrangement 130 differs from the first vacuum pump arrangement 70 is that it includes a first abatement module 110 in the form of a hot oxidizer 132 which is located downstream of the first primary pump 72. In still further embodiments of the invention the hot oxidizer 132 may be located at the interstage 114 of the first primary pump 72.

A further difference in the second vacuum pump arrangement 130 is that it includes separate third and fourth wet scrubbers 134, 136 each of which is fluidly connected downstream of a respective one of the first or second primary pumps 72, 88. Such an arrangement allows for further optimisation of each wet scrubber 134, 136 according to the nature of the process flow it is intended to handle.

More particularly the third wet scrubber 134 is arranged downstream of the hot oxidizer 132, and so defines a 'second' abatement module from the perspective of the first primary pump 72.

The third wet scrubber 134 and the hot oxidizer 132 are fluidly interconnected by a first common scrubber line 120 which, in use, is fluidly connected to a similar first common scrubber line 120 of another vacuum pumping arrangement (not shown). In this manner the single third wet scrubber 134 is able to service a number of first primary pumps 72 in otherwise separate second semiconductor fabrication tools 86.

Meanwhile the fourth wet scrubber 136 is arranged immediately downstream of the second primary pump 88, and so defines a 'first' abatement module from the perspective of the second primary pump 88.

A second common scrubber line 122 which, in use, is fluidly connected to a similar second common scrubber line 122 of another vacuum pumping arrangement (not shown), fluidly connects the fourth wet scrubber 136 with the second primary pump 88. In this manner the single fourth wet scrubber 136 is able to service a number of second primary pumps 88 in otherwise separate second semiconductor fabrication tools 86. Thus the chemically similar, or compatible gases conveyed (collated) from several vacuum pumping arrangements in a particular common pumping line can be serviced by a single, or plurality of optimised abatement devices. Even if a plurality of optimised abatement device are required to service the exhaust gases from several interconnected common pumping lines, the redundancy provided by the present invention should still achieve a reduction in the total number of abatement devices required to be active at any point in time compared to the non-interconnected vacuum pumping arrangements of figures 4 and 5.

In addition, the second vacuum pumping arrangement 130 differs from the first vacuum pumping arrangement 70 in that only two of the first booster pumps 50 are on the same floor 60 as, and are mounted on, the corresponding process chamber 22. The other two first booster pumps are located on a different floor to the corresponding process chamber 22, and hence are spaced further from the corresponding process chamber 22.

Otherwise, in use, the fourth vacuum pumping arrangement 130 operates in essentially the same manner as the first vacuum pumping arrangement 70, i.e. with the first primary pump 72 and the first common pumping line 78 handling a deposition process flow, and the second primary pump 88 and the second common pumping line 94 handling a cleaning process flow.

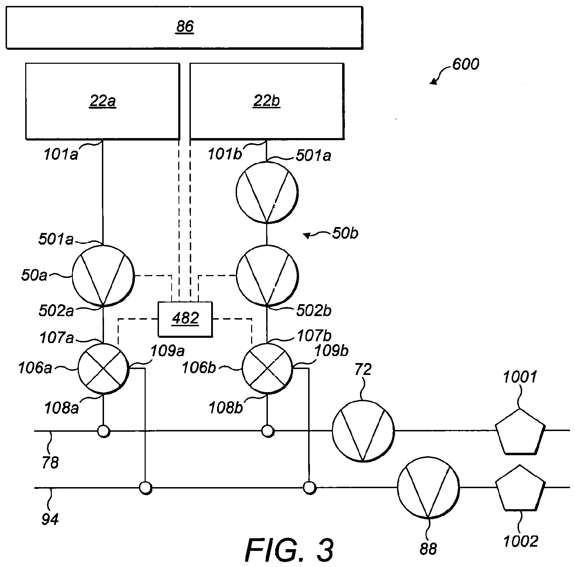

Figure 3 illustrates schematically a third vacuum pumping arrangement for evacuating at least a first and second vacuum process chamber 22a and 22b of a process tool 86. At least two process steps are carried out in each chamber 22a, 22b, for example a deposition step and a chamber clean or an etch step. The vacuum pumping arrangement 600 comprises first and second secondary vacuum pumps 50a and 50b respectively, selected from, for example, at least one of a roots booster and/or turbomolecular pump. The first secondary vacuum pump 50a comprises an inlet 501a and outlet 502a. The first secondary pump inlet 501a is in fluid communication with an outlet 101a of the first process chamber 22a. The second secondary vacuum pump 50b comprises an inlet 501b and outlet 501b. The second secondary vacuum pump inlet 501b is in fluid communication with an outlet 101b of the second process chamber 22b. The arrangement 600 also comprises first and second three way valve modules 106a, 106b. The first valve module 106a comprises an inlet 107a, a first outlet 108a and a second outlet 109a, said first valve module inlet 107a is in fluid communication with the outlet 502a of the first secondary vacuum pump 50a. The second valve module 106b comprises an inlet 107b, a first outlet 108b and a second outlet 109b. The second valve inlet 107b is in fluid communication with an outlet 501b of the second secondary vacuum pump 50b. The arrangement further comprises first and second common pumping lines 78, 94 respectively. The first common pumping line 78 is in fluid communication with the first outlets 108a, 108b of both of the first and second valve modules 106a, 106b. The second common pumping line 94 is in fluid communication with the second outlets 109a, 109b of both the first and second valve modules 106a, 106b.

The first and second common pumping lines 78, 94 comprise a respective first and second primary vacuum pump 72, 88, selected from, for example, at least one of a multistage claw and/or roots, screw, scroll, rotary vane and liquid ring vacuum pump and chosen to provide sufficient pumping capacity for evacuating the first and second chambers 22a, 22b and backing each of the first and second secondary vacuum pumps 50a, 50b when in fluid communication via the first and/or second valve modules 106a, 106b. For example, if the first and second three way valve modules 106a and 106b are fluidly connecting both the first and second process chambers 22a, 22b via the first and second secondary pumps 50a, 50b to the first common pumping line 78 (because, for example a deposition step is being carried out in both the first and second chambers 22a, 22b), then the first primary pump 72 must be of sufficient pumping capacity to ensure the pressure in each chamber 22a, 22b is stable.

To this end the arrangement 600 also comprises a controller 482 to control both the operational state of the first and second three way valves (to determine which common pumping line 78, 94 the gas exhausted from the chambers 22a, 22b is conveyed to); and the rotational speed of the first and/or second primary pumps based on a signal from the process tool (or equivalent device such as a central information system) indicating the composition of the gases being exhausted from each chamber 22a, 22b.

In addition, the first and second primary pumps 72, 88 are chosen depending on the composition and flow rates of exhaust gases directed to each of the at least first and second common pumping lines 78, 94. For example if the first set of compatible gases to be conveyed to the first common pumping line 78 are powder forming gases, such as TEOS or silane, then the first primary pump 72 used can be a screw pump, or multistage dry vacuum pump operating at temperatures above 80 °C to 100 °C with large amounts of nitrogen purge to prevent powder collecting the in the mechanism. Similarly, if the second set of compatible gases to be conveyed to the second common pumping line 94 are halogenated gases, such as those used in cleaning or etch steps, then the second primary pump 88, can be a multistage roots or claw dry pump which is operated at a temperature below 80 °C to 100 °C.

Each of the common pumping lines 78, 94 are in fluid communication with an abatement device 1001, 1002 respectively, both chosen to optimise the abatement of the exhaust gases conveyed to each of the common pumping lines 78, 94 from the chamber 22a, 22b. For example, if the first set of compatible gases to be conveyed to the first abatement device are flammable, or powder forming gases, such as SiH₄/N₂O or TEOS/O₃ which are often used in the deposition steps, then DC plasma device may be the most suitable abatement device to complete the reaction between unreacted precursor gases; whereas if the second set of compatible gases to be conveyed to the second common pumping line 94 are halogenated gases such as NF₃/F₂ or any of the PFCs, which are often used as chamber cleaning gases, then the second abatement device 1001 could preferably be and RF plasma device into which oxygen is supplied for the destruction of PFCS such as CF₄, C₂F₆, etc., (which would not be safe for the deposition gases mentioned above).

The controller 482 can also be configured to control the first and/or second abatement devices 1001, 1001 (for example turning them off when not required to save energy)

The provision of the at least three way valve modules 106a, 106b for each process chamber 22a, 22b respectively, and a plurality of common pumping lines 78, 94 in fluid communication with the outlets of said valve modules 106a, 106b allows, in use, for common process flows, namely chemically similar, or compatible, unused process gasses (precursors) and their by-products exhausted from different process chambers 22a, 22b to be directed, via the valve modules 106a, 106b, to the desired common pumping line 78, 94. Thus, the chemically similar, or compatible, unused process gasses and their by-products directed to each common pumping conduit 78, 94 can then be treated in a more specific, suitable, and therefore efficient, abatement device for said exhaust gas flow type.

If more than two chemically incompatible exhaust gas species or mixtures are exhausted from the process chambers 22a, 22b then the valve modules 106a, 106b will be chosen to have a corresponding number of outlets and there will need to be a corresponding number of common pumping lines; for example if the process chambers 22a, 22b carried out three separate steps, all of which produced three different types of incompatible gas species, then the valve modules 106a, 106b would comprise three outlets (not shown) all conveying the specific exhaust gases to a first, second and third common pumping lines with first, second and a third primary pumps and first, second and, if necessary, third abatement devices respectively.

Similarly if the process tool comprises more than two process chambers, each additional chamber will have at least one three way valve module 106 and at least one secondary pump 50 associated therewith to convey the exhaust gases to the first or second (or third etc.) common pumping lines 78, 94.

As with the previous examples, it is advantageous for at least one of the common pumping lines 78, 94 to be in fluid communication with a corresponding common pumping line of another process tool (not shown) to enable a level of both primary pump and abatement device redundancy between process tools in the semiconductor fabrication plant.

## Claims

1. A vacuum pumping arrangement (70) comprising:
a first primary pump (72) having an inlet (74) and an outlet (76), and a first common pumping line (78) fluidly connected to the inlet of the first primary pump, the first common pumping line including a plurality of first common pumping line inlets (80) each of which is fluidly connectable to at least one vacuum process chamber (22) within the group of process chambers forming a semiconductor fabrication tool (86), the first primary pump and the first common pumping line, in use, handling deposition process flows; and
a second primary pump (88) having an inlet (90) and an outlet (92), and a second common pumping line (94) fluidly connected to the inlet of the second primary pump, the second common pumping line including a plurality of second common pumping line inlets (96) each of which is fluidly connectable to at least one process chamber within a group of process chambers forming the semiconductor fabrication tool, the second primary pump and the second common pumping line, in use, handling cleaning process flows, **characterised in that** respective pairs of first and second common pumping line inlets are each fluidly interconnected by a valve module (106) which in turn is fluidly connectable to a said at least one process chamber such that an exhaust of said at least one process chamber is directed to either said first or second common pumping line.

2. A vacuum pumping arrangement according to Claim 1 wherein each of the first and second primary pumps has a respective abatement module (1001, 1002) arranged in fluid communication therewith.

3. A vacuum pumping arrangement according to Claim 1 or 2, wherein at least one valve module includes a fail-safe arrangement to prevent mixing of deposition and cleaning process flows upstream of the valve module.

4. A vacuum pumping arrangement according to any preceding Claim wherein at least one valve module is located downstream of any booster pump connectable with the corresponding process chamber.

5. A vacuum pumping arrangement according to any preceding claim wherein the second common pumping line is selectively fluidly connectable with the first primary pump.

6. A vacuum pumping arrangement according to any preceding claim wherein at least one common pumping line includes an interconnecting member fluidly connectable to a common pumping line of at least one other vacuum pumping arrangement.

7. A vacuum pumping arrangement according to any preceding claim further including one or more rough down pumping lines, each having a first end arranged in fluid communication with a primary pump and a second end including a bleed valve, the bleed valve being fluidly connectable to a respective process chamber to initially evacuate the said process chamber.

8. A semiconductor fabrication facility (86) comprising a plurality of semiconductor fabrication tools each of which includes:
a plurality of process chambers (22); and
a vacuum pumping arrangement according to any preceding claim,
wherein the common pumping line of the vacuum pumping arrangement of one semiconductor fabrication tool is fluidly connected to the common pumping line of the vacuum pumping arrangement of at least one other semiconductor fabrication tool.

9. A vacuum pumping arrangement according to any one of claims 1 to 7 for evacuating at least first and second vacuum process chambers, comprising a first vacuum pump (50a) having an inlet (501a) and a second vacuum pump (50b) having an inlet (101b), wherein said first vacuum pump inlet (501a) is adapted to be in fluid communication with an outlet of the first process chamber, said second vacuum pump inlet (101b) is adapted to be in fluid communication with an outlet of the second process chamber; at least first and second valve modules (108a, 108b), said valve modules being at least three way valve modules comprising an inlet, a first outlet and a second outlet, said first valve module inlet in fluid communication with an outlet of the first vacuum pump, said second valve module inlet in fluid communication with an outlet of the second vacuum pump; said first common pumping line (78) being in fluid communication with the first outlets of both of the first and second valve modules, the second common pumping line (94) being in fluid communication with the second outlets of both the first and second valve modules, wherein the first and second vacuum pumps (50a, 50b) are secondary vacuum pumps and each of the first and second common pumping lines comprises at least respective first and second primary vacuum pumps (72, 88) to provide sufficient pumping capacity for each of the at least first and second vacuum pumps when in fluid communication via the first and/or second valve modules; and wherein at least one of the common pumping lines is in fluid communication with an abatement device (1001, 1002).

## Patentansprüche

1. Vakuumpumpenanordnung (70), die aufweist:
eine erste Primärpumpe (72) mit einem Einlass (74) und einem Auslass (76), und einer ersten gemeinsamen Pumpenleitung (78), die strömungstechnisch mit dem Einlass der ersten Primärpumpe verbunden ist, wobei die erste gemeinsame Pumpenleitung eine Mehrzahl von ersten gemeinsamen Pumpenleitungseinlässen (80) aufweist, von denen jeder strömungstechnisch mit mindestens einer Vakuumprozesskammer (22) innerhalb der Gruppe von Prozesskammern verbindbar ist, die ein Halbleiterfabrikationswerkzeug (86) bilden, wobei die erste Primärpumpe und die erste gemeinsame Pumpenleitung im Betrieb die Entsorgung von Prozessströmungen handhaben, und
eine zweite Primärpumpe (88) mit einem Einlass (90) und einem Auslass (92), und einer zweiten gemeinsamen Pumpenleitung (94), die strömungstechnisch mit dem Einlass der zweiten Primärpumpe verbunden ist, wobei die zweite gemeinsame Pumpenleitung eine Mehrzahl von zweiten gemeinsamen Pumpenleitungseinlässen (96) aufweist, von denen jede strömungstechnisch mit mindestens einer Prozesskammer innerhalb einer Gruppe von Prozesskammern verbindbar ist, welche das Halbleiterfabrikationswerkzeug bilden, wobei die zweite Primärpumpe und die zweite gemeinsame Pumpenleitung im Betrieb Reinigungsprozessströme handhaben,
**dadurch gekennzeichnet, dass**
jeweilige Paare von ersten und zweiten gemeinsamen Pumpenleitungseinlässen strömungstechnisch durch einen Ventilmodul (106) verbunden sind, der wiederum strömungstechnisch mit einer genannten mindestens einen Prozesskammer verbindbar ist, derart, dass ein Abgas der mindestens einen Prozesskammer in entweder die erste oder die zweite gemeinsame Pumpenleitung geleitet wird.

2. Vakuumpumpenanordnung nach Anspruch 1, wobei in Strömungsverbindung mit jeder der ersten und der zweiten Primärpumpe ein jeweiliger Entfernungsmodul (1001, 1002) angeordnet ist.

3. Vakuumpumpenanordnung nach Anspruch 1 oder 2, wobei mindestens ein Ventilmodul eine ausfallsichere Anordnung zur Verhinderung einer Vermischung von Entsorgungs- und Reinigungsprozessströmen stromauf des Ventilmoduls enthält.

4. Vakuumpumpenanordnung nach irgendeinem vorhergehenden Anspruch, wobei mindestens ein Ventilmodul stromab einer etwaigen Vorpumpe angeordnet ist, die mit der entsprechenden Prozesskammer verbindbar ist.

5. Vakuumpumpenanordnung nach irgendeinem vorhergehenden Anspruch, wobei die zweite gemeinsame Pumpenleitung wahlweise strömungstechnisch mit der ersten Primärpumpe verbindbar ist.

6. Vakuumpumpenanordnung nach irgendeinem vorhergehenden Anspruch, wobei mindestens eine gemeinsame Pumpenleitung ein Verbindungsbauteil enthält, das strömungstechnisch mit einer gemeinsamen Pumpenleitung mindestens einer anderen Vakuumpumpenanordnung verbindbar ist.

7. Vakuumpumpenanordnung nach irgendeinem vorhergehenden Anspruch, mit einer oder mehreren Grobpumpenleitungen, die jeweils ein erstes, in Strömungsverbindung mit einer Primärpumpe angeordnetes Ende und ein zweites, ein Anzapfventil aufweisendes zweites Ende haben, wobei das Anzapfventil strömungstechnisch mit einer jeweiligen Prozesskammer verbindbar ist, um die Prozesskammer anfänglich zu evakuieren.

8. Halbleiterfabrikationsanlage (86) mit einer Mehrzahl von Halbleiterfabrikationswerkzeugen, von denen jedes aufweist:
eine Mehrzahl von Prozesskammern (22); und
eine Vakuumpumpenanordnung nach irgendeinem vorhergehenden Anspruch, wobei die gemeinsame Pumpenleitung der Vakuumpumpenanordnung eines Halbleiterfabrikationswerkzeugs strömungstechnisch mit der gemeinsamen Pumpenleitung der Vakuumpumpenanordnung mindestens eines weiteren Halbleiterfabrikationswerkzeugs verbunden ist.

9. Vakuumpumpenanordnung nach einem der Ansprüche 1 bis 7 zum Evakuieren mindestens erster und zweiter Prozesskammern, mit einer ersten Vakuumpumpe (50a) mit einem Einlass (501a) und einer zweiten Vakuumpumpe (50b) mit einem Einlass (101b), wobei der erste Vakuumpumpeneinlass (501a) für eine Strömungsverbindung mit einem Auslass der ersten Prozesskammer ausgebildet ist, der zweite Vakuumpumpeneinlass (101b) für eine Strömungsverbindung mit einem Auslass der zweiten Prozesskammer ausgebildet ist, mindestens ein erster und ein zweiter Ventilmodul (108a, 108b) vorhanden ist, die Ventilmodule mindestens Dreiwege-Ventilmodule mit einem Einlass, einem ersten Auslass und einem zweiten Auslass sind, der erste Ventilmoduleinlass in Strömungsverbindung mit einem Auslass der ersten Vakuumpumpe steht, der zweite Ventilmoduleinlass in Strömungsverbindung mit einem Auslass der zweiten Vakuumpumpe steht, die erste gemeinsame Pumpenleitung (78) in Strömungsverbindung mit den ersten Auslässen sowohl des ersten als auch des zweiten Ventilmoduls steht, die zweite gemeinsame Pumpenleitung (94) in Strömungsverbindung mit den zweiten Auslässen sowohl des ersten als auch des zweiten Ventilmoduls steht, wobei die erste und die zweite Vakuumpumpe (50a, 50b) Sekundärvakuumpumpen sind und die erste und die zweite gemeinsame Pumpenleitung jeweils eine entsprechende erste und zweite Primärvakuumpumpe (72, 88) zum Bereitstellen ausreichender Pumpenkapazität für jede der mindestens ersten und zweiten Vakuumpumpen aufweisen, wenn sie über den ersten und/oder zweiten Ventilmodul in Strömungsverbindung stehen, und wobei mindestens eine der gemeinsamen Pumpenleitungen in Strömungsverbindung mit einer Entfernungseinrichtung (1001, 1002) steht.

## Revendications

1. Agencement de pompage par le vide (70) comprenant :
une première pompe (72) primaire ayant une entrée (74) et une sortie (76), et une première canalisation de pompage commune (78) raccordée fluidiquement à l'entrée de la première pompe primaire, la première canalisation de pompage commune incluant une pluralité de premières entrées de canalisation de pompage commune (80) dont chacune peut être raccordée fluidiquement à au moins une chambre de traitement sous vide (22) au sein du groupe de chambres de traitement formant un outil de fabrication de semi-conducteur (86), la première pompe primaire et la première canalisation de pompage commune, en utilisation, manipulant des flux de traitement de dépôt ; et
une seconde pompe (88) primaire ayant un orifice d'admission (90) et un orifice de refoulement (92), et une seconde canalisation de pompage commune (94) raccordée fluidiquement à l'orifice d'admission de la seconde pompe primaire, la seconde canalisation de pompage commune incluant une pluralité de seconds orifices d'admission de canalisation de pompage commune (96) dont chacun peut être raccordé fluidiquement à au moins une chambre de traitement au sein d'un groupe de chambres de traitement formant l'outil de fabrication de semi-conducteur, la seconde pompe primaire et la seconde canalisation de pompage commune, en utilisation, manipulant des flux de traitement de nettoyage, **caractérisé en ce que** des paires respectives de premier et second orifices d'admission de canalisation de pompage commune sont reliés chacun fluidiquement par un module de vanne (106) qui quant à lui peut être raccordé fluidiquement à ladite au moins une chambre de traitement de sorte qu'une évacuation de ladite au moins une chambre de traitement soit dirigée vers soit ladite première soit ladite seconde canalisation de pompage commune.

2. Agencement de pompage par le vide selon la revendication 1, dans lequel chacune des première et seconde pompes primaires a un module de réduction (1001, 1002) respectif agencé en communication fluidique avec celles-ci.

3. Agencement de pompage par le vide selon la revendication 1 ou 2, dans lequel au moins un module de vanne inclut un agencement de sécurité pour empêcher le mélange de flux de traitement de nettoyage et de dépôt en amont du module de vanne.

4. Agencement de pompage par le vide selon une revendication précédente quelconque, dans lequel au moins un module de vanne est situé en aval de toute pompe de surpression pouvant être raccordée à la chambre de traitement correspondante.

5. Agencement de pompage par le vide selon une revendication précédente quelconque, dans lequel la seconde canalisation de pompage commune peut être sélectivement raccordée fluidiquement à la première pompe primaire.

6. Agencement de pompage par le vide selon une revendication précédente quelconque, dans lequel au moins une canalisation de pompage commune inclut un organe d'interconnexion pouvant être raccordé fluidiquement à une canalisation de pompage commune d'au moins un autre agencement de pompage par le vide.

7. Agencement de pompage par le vide selon une revendication précédente quelconque, incluant en outre une ou plusieurs canalisations de pompage de dégrossissage, ayant chacune une première extrémité agencée en communication fluidique avec une pompe primaire et une seconde extrémité incluant une vanne de purge, la vanne de purge pouvant être raccordée fluidiquement à une chambre de traitement respective pour évacuer initialement ladite chambre de traitement.

8. Installation de fabrication de semi-conducteur (86) comprenant une pluralité d'outils de fabrication de semi-conducteur dont chacun inclut :
une pluralité de chambres de traitement (22) ; et
un agencement de pompage par le vide selon une revendication précédente quelconque,
dans laquelle la canalisation de pompage commune de l'agencement de pompage par le vide d'un outil de fabrication de semi-conducteur est raccordée fluidiquement à la canalisation de pompage commune de l'agencement de pompage par le vide d'au moins un autre outil de fabrication de semi-conducteur.

9. Agencement de pompage par le vide selon l'une quelconque des revendications 1 à 7 pour évacuer au moins des première et seconde chambres de traitement sous vide, comprenant une première pompe à vide (50a) ayant un orifice d'admission (501a) et une seconde pompe à vide (50b) ayant un orifice d'admission (101b), dans lequel ledit premier orifice d'admission de pompe à vide (501a) est adapté pour être en communication fluidique avec un orifice de refoulement de la première chambre de traitement, ledit premier orifice d'admission de pompe à vide (101b) est adapté pour être en communication fluidique avec un orifice de refoulement de la seconde chambre de traitement ; au moins des premier et second modules de vanne (108a, 108b), lesdits modules de vanne étant au moins des modules de vanne à trois voies comprenant un orifice d'admission, un premier orifice de refoulement, et un second orifice de refoulement, ledit orifice d'admission du premier module de vanne est en communication fluidique avec un orifice de refoulement de la première pompe à vide, ledit orifice d'admission du second module de vanne en communication fluidique avec un orifice de refoulement de la seconde pompe à vide ; ladite première canalisation de pompage commune (78) étant en communication fluidique avec les premiers orifices de refoulement à la fois des premier et second modules de vanne, la seconde canalisation de pompage commune (94) étant en communication fluidique avec les seconds orifices de refoulement à la fois des premier et second modules de vanne, dans lequel les première et seconde pompes à vide (50a, 50b) sont des pompes à vide secondaires et chacune des première et seconde canalisations de pompage communes comprend au moins des première et seconde pompes (72, 88) à vide primaires respectives pour fournir une capacité de pompage suffisante à chacune des au moins première et seconde pompes à vide lorsqu'elles sont en communication fluidique via les premier et/ou second modules de vanne ; et dans lequel au moins l'une des canalisations de pompage communes est en communication fluidique avec un dispositif de réduction (1001, 1002).
